# EUROPEAN PATENT SPECIFICATION

(11) **EP 2 628 179 B1**
(45) Date of publication and mention of the grant of the patent: **15.08.2018**
(21) Application number: 11784533.9
(22) Date of filing: 13.10.2011
(51) Int. Cl.: H01L 23/14, H01L 23/498

(54) **METHOD AND APPARATUS FOR IMPROVING SUBSTRATE WARPAGE**
VERFAHREN UND VORRICHTUNG ZUR VERBESSERUNG VON SUBSTRATVERZUG
PROCÉDÉ ET DISPOSITIF PERMETTANT DE RÉDUIRE LE GAUCHISSEMENT D'UN SUBSTRAT

(30) Priority: 15.07.2011 US 201113183875; 13.10.2010 US 392634 P
(43) Date of publication of application: 21.08.2013
(73) Proprietor: Qualcomm Incorporated, San Diego, CA 92121 (US)
(72) Inventor: BCHIR, Omar J., San Diego, California 92121 (US); SHAH, Milind P., San Diego, California 92121 (US); MOVVA, Sashidhar, San Diego, California 92121 (US)
(74) Representative: Dunlop, Hugh Christopher
(86) International application number: PCT/US2011/056077
(87) International publication number: WO 2012/051375

(56) References cited:
- EP-A2- 0 244 699
- JP-A- 2009 231 431
- US-A- 4 513 055
- US-A- 4 874 809
- US-A- 5 300 735
- US-A1- 2005 218 503

## Description

### CROSS REFERENCE TO RELATED APPLICATION

The present application claims the benefit of U.S. Provisional Patent Application No. 61/392,634, filed October 13, 2011, in the names of BCHIR et al.

### TECHNICAL FIELD

The present disclosure generally relates to integrated circuits (ICs). More specifically, the present disclosure relates to dielectric layer modification to reduce substrate warpage.

### BACKGROUND

Current integrated circuits use thin substrates which are prone to warpage. The warpage is due to the use of multiple types of materials, such as metal, dielectric and composites in the substrate which have mismatched CTE (coefficient of thermal expansion) values. The warpage may lead to chip attach yield loss and board mount assembly yield loss in production. Additionally, warpage may also cause dielectric layer delamination (e.g., ELK cracking). Thus, there is a need for reducing warpage in the integrated circuit. US2005218503 discloses a fiber reinforced resin board for reducing the warpage of a multilayer wiring board, with layers reinforced by fibers with a negative CTE and other layers reinforced by fibers with a positive CTE.

### BRIEF SUMMARY

According to the present invention, the problem is solved by the package substrate according to claim 1 and the method according to claim 8. Advantageous additional aspects follow from the dependent claims.

This has outlined, rather broadly, the features and technical advantages of the present disclosure in order that the detailed description that follows may be better understood. Additional features and advantages of the disclosure will be described below. It should be appreciated by those skilled in the art that this disclosure may be readily utilized as a basis for modifying or designing other structures for carrying out the same purposes of the present disclosure. It should also be realized by those skilled in the art that such equivalent constructions do not depart from the teachings of the disclosure as set forth in the appended claims. The novel features, which are believed to be characteristic of the disclosure, both as to its organization and method of operation, together with further objects and advantages, will be better understood from the following description when considered in connection with the accompanying figures. It is to be expressly understood, however, that each of the figures is provided for the purpose of illustration and description only and is not intended as a definition of the limits of the present disclosure.

### BRIEF DESCRIPTION OF THE DRAWINGS

For a more complete understanding of the present disclosure, reference is now made to the following description taken in conjunction with the accompanying drawings.
FIGURE 1 is a flow chart illustrating a conventional method for strip assembly.
FIGURE 2 is a flow chart illustrating a conventional method for unit assembly.
FIGURE 3 shows cross-sectional views illustrating a conventional package substrate.
FIGURE 4 shows cross-sectional views illustrating an enhanced package substrate.
FIGURE 5 shows cross-sectional views illustrating another embodiment of an enhanced package substrate.
FIGURE 6 is a block diagram showing an exemplary wireless communication system in which an embodiment of the disclosure may be advantageously employed.
FIGURE 7 is a block diagram illustrating a design workstation used for circuit, layout, and logic design of a semiconductor component according to one embodiment.

### DETAILED DESCRIPTION

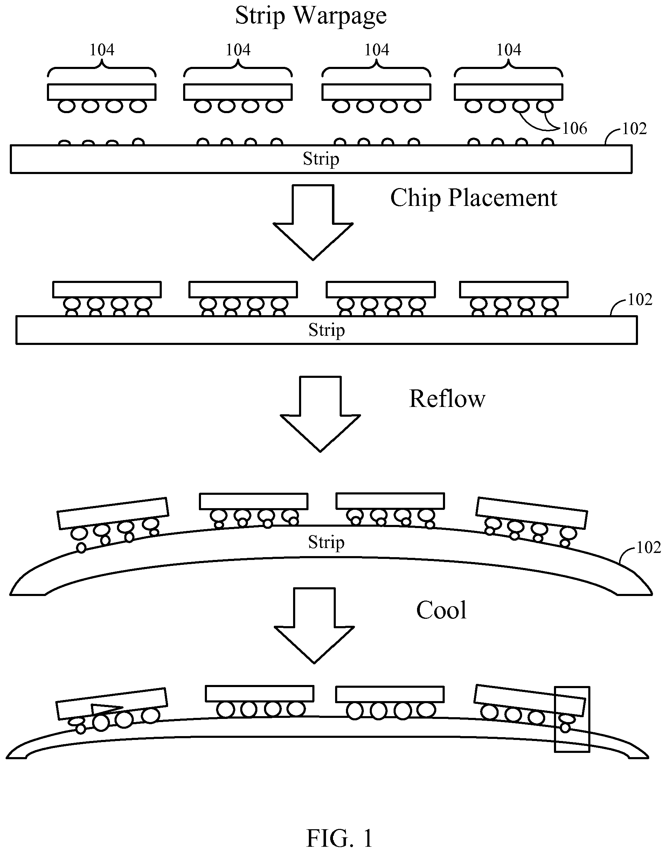

FIGURE 1 illustrates a conventional method for strip assembly. Multiple package substrates, such as die 104, are intended for placement on a panel, sub-panel, strip or unit array 102. A tacky material 106 is applied to the die 104 to secure the die to the strip 102. Assembly of the strip 102 with the secured die thereon occurs in a chip attach machine (not shown). The entire assembled strip is then heated in a reflow oven and then left to cool.

The die 104 tend to have a CTE (coefficient of thermal expansion) of about 3 ppm/°C. The strip 102 has a CTE of about 17 ppm/°C or greater. Thermal expansion is the tendency of matter to change in volume in response to a change in temperature. For a particular material, the degree of expansion divided by the change in temperature is called the material's coefficient of thermal expansion (CTE). The significant mismatch of thermal expansion of the die 104 and strip 102 tends to cause bowing and warpage during assembly.

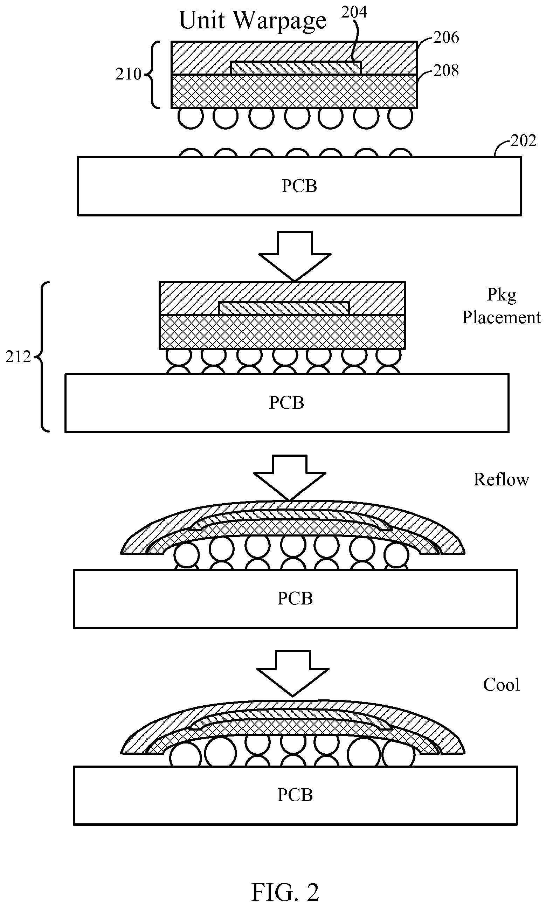

FIGURE 2 illustrates a conventional method for unit level assembly. Here, the die 204 is attached to a substrate 208 and surrounded with mold compound 206 and the resulting assembled package 210 may be shipped to a customer for further processing. A customer mounts the received package 210 to a printed circuit board (PCB) 202. Often, in this mounting process, a paste is applied to the circuit board 202 and the package 210 is placed on the paste. The resulting assembly 212 is then heated. The circuit board 202 can be thick and does not tend to have as much warpage as the package. Warpage tends to occur more in the package 210. If there is a significant amount of warpage in the package 210, then a solder joint non-wet situation may result at the customer site, which may then result in yield loss.

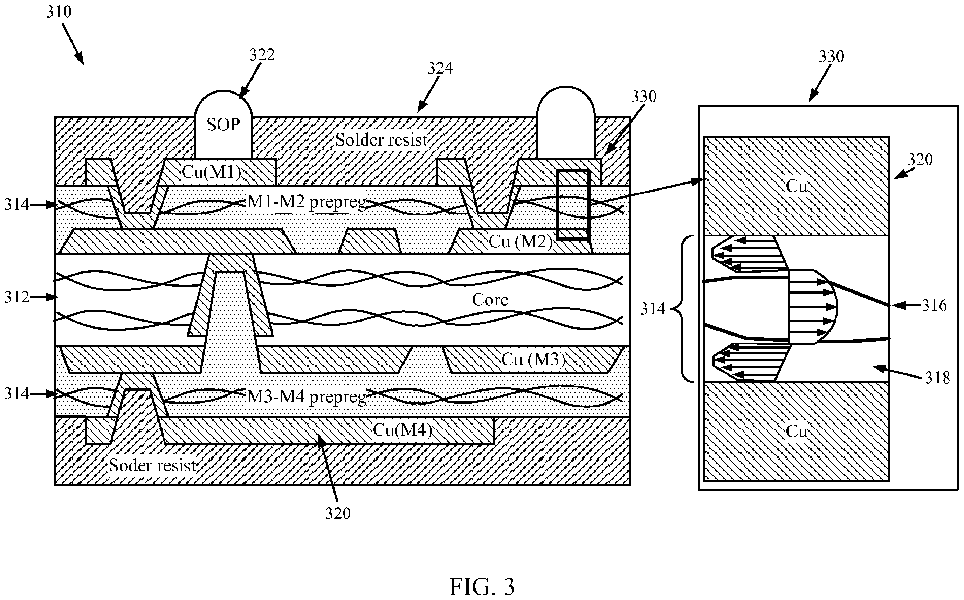

FIGURE 3 illustrates a cross-sectional view of a conventional package substrate 310. The substrate 310 includes a core material 312, conductive interconnects 320 (e.g. copper), solder resist coating 324, and SOP (solder on pad) 322. The substrate 310 also includes a pre-impregnated composite material (pre-preg) 314 that contains glass fibers 316 and a neat resin 318 with fillers around it. Optionally, the pre-impregnated composite material may include an epoxy resin that contains silica particles and a polymer, which expand and shrink. In current solutions, the resin of the pre-impregnated composite materials are usually cured through the addition of heat. After the layup process, the pre-impregnated composite material is cured on either side of the core in a lamination press. During cool down from the curing process, the resin around the glass tends to shrink more than the glass fiber or the metal. In one example, the glass fiber 316 of the pre-impregnated composite material 314 has a CTE of about 5 ppm/°C and the neat resin 318 has a CTE of about 31 ppm/°C. The copper metal interconnect 320 has a CTE near 17 ppm/°C. In this example, a material with a CTE of 17 (i.e., the copper) is adjacent a material with a CTE of 31 (i.e., the neat resin) that is attached to a material with a CTE of 5 (i.e., the glass fiber). During the curing process, when the temperature goes from a high temperature and then cools down, all of these materials are shrinking at different rates. This results in significant residual stresses trapped in the cured pre-impregnated composite material layer 314.

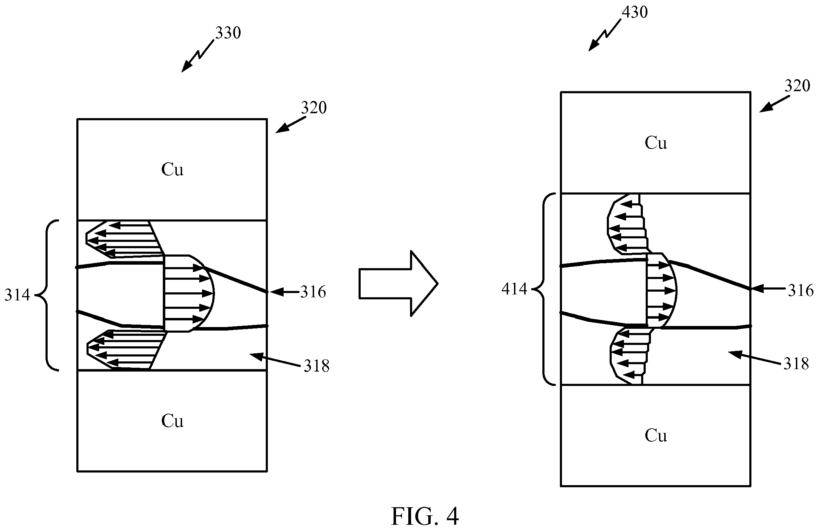

Referring to FIGURE 4, a blown-up cross-sectional view 330 of a portion of the package substrate is shown as well as a view of an enhanced substrate 430. In particular, the package substrate 430 includes a thicker layer of pre-impregnated composite material 414. The layer of pre-impregnated composite material 414 is thicker than pre-impregnated layer 314 because more resin 318 has been added to the pre-impregnated composite material layer. In one embodiment this does not impact the overall thickness of the die, but may increase the overall thickness of the package. In particular, the thickness of the substrate (and thus the overall package) is increased when the pre-impregnated composite material is thicker, but the die thickness remains unchanged. In one configuration, the pre-impregnated composite material layer 414 has a thickness of about 45 microns on either side of a core layer, which is thicker than the conventional substrate package 310 in which the pre-impregnated composite material layer 314 may have a thickness of about 35 microns.

Optionally, in one embodiment, the thickness of the pre-impregnated composite material layer 414 is evenly increased, meaning the thickness of both the front and back layers are increased by about the same amount. A uniform increase in thickness correlates to a reduction in warpage. For example, if a substrate were configured such that the thickness was 35 microns on one side and 55 microns on the other side, then warpage could result due to the large difference in layer thickness between the sides. However, if one side is 34 microns and the other side is 38 microns, then warpage will likely not result since the delta (difference in thickness between sides) is small.

Conventional substrate packaging assembly suggested forming a thinner pre-impregnated composite material layer to reduce warpage. Conventional practice further suggested that if the pre-impregnated composite material layer was thinned by reducing the amount of resin in the layer, then the CTE would also be lower because the ratio of glass to resin is higher, thus making the CTE lower. For example, glass fiber has a CTE of 5 and an epoxy resin has a CTE of 31. Conventional methods have suggested that to reduce the amount of neat resin, increasing the relative CTE ratio of glass to resin would decrease the overall CTE of the pre-impregnated composite material. However, the embodiment illustrated in FIGURE 4 is contrary to this concept, as a thicker pre-impregnated composite material is implemented and results in a reduction in the occurrence of warpage. In particular, using the thicker pre-impregnated composite material layer 414 results in a lower amount of trapped residual stress. Adding more resin to increase the thickness of the pre-impregnated composite material layer increases the amount of time it takes for the pre-impregnated composite material to cool, thereby allowing for a closer approach to equilibrium. In other words, the resin, filler and glass fiber in the pre-impregnated composite material layer moves for a longer period of time and relieves residual stresses.

In one embodiment, the pre-impregnated composite material is made thicker by adding more resin 318, rather than by increasing the content of glass fiber 316. In one embodiment the resin content is about 74% resin and about 26% glass fiber. Further, the pre-impregnated composite material may also include fillers other than resin and glass.

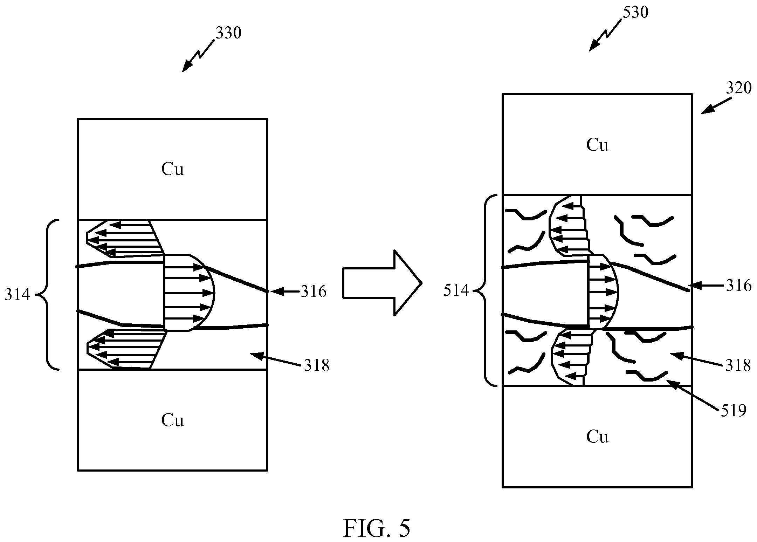

In another embodiment, a package substrate includes a dielectric having a resin doped with a negative CTE fiber. Referring to FIGURE 5, blown-up cross-sectional views of a package substrate 330, 530 are shown. The pre-impregnated composite material layer 514 includes glass fibers 316, resin 318 and fibers 519 having a negative CTE value. When the fiber 519 is heated, the fibers shrink with increased temperature, which is contrary to standard glass and epoxy. The fiber 519 reduces the effective CTE of the resin 318 and thereby reduces the trapped residual stresses between the glass fibers 316 and copper material 320.

In one embodiment, the fibers 519 are aramid fibers. Generally, aramid fibers are a class of heat-resistant and strong synthetic fibers. Optionally, in one embodiment, the pre-impregnated composite material layer includes Thermount,® a nonwoven aramid fiber by DuPont. Those skilled in the art will appreciate the pre-impregnated composite material layer 514 may be doped with other materials having a negative CTE value. In one embodiment, the pre-impregnated composite material layer 514 continues to include glass fibers, or any other material with the same stiff characteristic and low CTE value as that of glass. Additionally, in another embodiment, the pre-impregnated composite material layer 514 is additionally thickened with additional resin material 518.

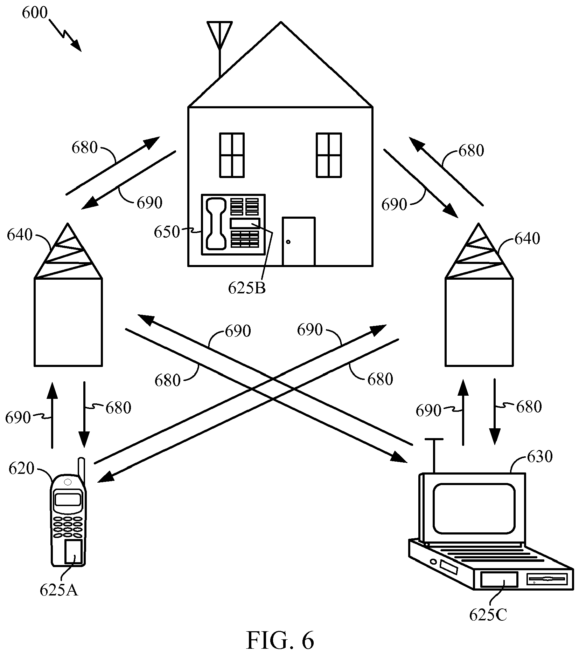

FIGURE 6 is a block diagram showing an exemplary wireless communication system 600 in which an embodiment of the disclosure may be advantageously employed. For purposes of illustration, FIGURE 6 shows three remote units 620, 630, and 650 and two base stations 640. It will be recognized that wireless communication systems may have many more remote units and base stations. Remote units 620, 630, and 650 include IC devices 625A, 625C and 625B, that include the disclosed modified dielectric layer. It will be recognized that any device containing an IC may also include a modified dielectric layer disclosed here, including the base stations, switching devices, and network equipment. FIGURE 6 shows forward link signals 680 from the base station 640 to the remote units 620, 630, and 650 and reverse link signals 690 from the remote units 620, 630, and 650 to base stations 640.

In FIGURE 6, remote unit 620 is shown as a mobile telephone, remote unit 630 is shown as a portable computer, and remote unit 650 is shown as a fixed location remote unit in a wireless local loop system. For example, the remote units may be mobile phones, hand-held personal communication systems (PCS) units, portable data units such as personal data assistants, GPS enabled devices, navigation devices, set top boxes, music players, video players, entertainment units, fixed location data units such as meter reading equipment, or any other device that stores or retrieves data or computer instructions, or any combination thereof. Although FIGURE 6 illustrates remote units according to the teachings of the disclosure, the disclosure is not limited to these exemplary illustrated units. Embodiments of the disclosure may be suitably employed in any device which includes a modified dielectric layer.

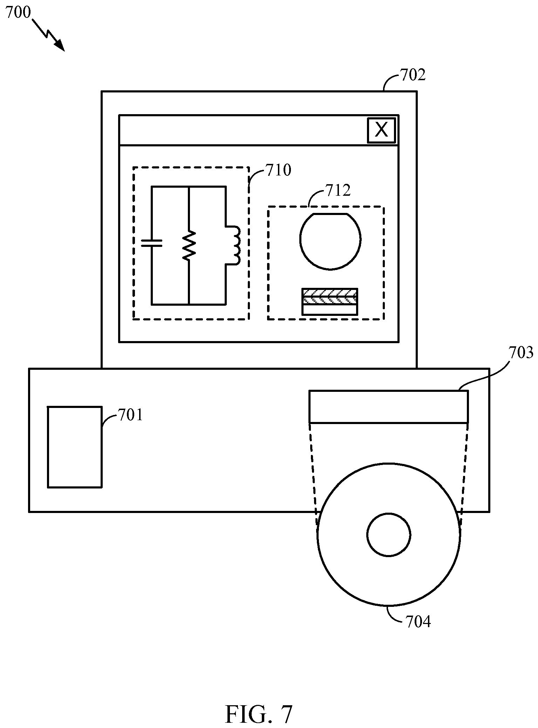

FIGURE 7 is a block diagram illustrating a design workstation used for circuit, layout, and logic design of a semiconductor component, including a modified dielectric layer as disclosed above. A design workstation 700 includes a hard disk 701 containing operating system software, support files, and design software such as Cadence or OrCAD. The design workstation 700 also includes a display to facilitate design of a circuit 710 or a semiconductor component 712 such as a packaged integrated circuit having a modified dielectric layer. A storage medium 704 is provided for tangibly storing the circuit design 710 or the semiconductor component 712. The circuit design 710 or the semiconductor component 712 may be stored on the storage medium 704 in a file format such as GDSII or GERBER. The storage medium 704 may be a CD-ROM, DVD, hard disk, flash memory, or other appropriate device. Furthermore, the design workstation 700 includes a drive apparatus 703 for accepting input from or writing output to the storage medium 704.

Data recorded on the storage medium 704 may specify logic circuit configurations, pattern data for photolithography masks, or mask pattern data for serial write tools such as electron beam lithography. The data may further include logic verification data such as timing diagrams or net circuits associated with logic simulations. Providing data on the storage medium 704 facilitates the design of the circuit design 710 or the semiconductor component 712 by decreasing the number of processes for designing semiconductor wafers.

For a firmware and/or software implementation, the methodologies may be implemented with modules (e.g., procedures, functions, and so on) that perform the functions described herein. Any machine-readable medium tangibly embodying instructions may be used in implementing the methodologies described herein. For example, software codes may be stored in a memory and executed by a processor unit. Memory may be implemented within the processor unit or external to the processor unit. As used herein the term "memory" refers to any type of long term, short term, volatile, nonvolatile, or other memory and is not to be limited to any particular type of memory or number of memories, or type of media upon which memory is stored.

Although the present disclosure and its advantages have been described in detail, it should be understood that various changes, substitutions and alterations can be made herein without departing from the technology of the disclosure as defined by the appended claims. For example, relational terms, such as "above" and "below" are used with respect to a substrate or electronic device. Of course, if the substrate or electronic device is inverted, above becomes below, and vice versa. Additionally, if oriented sideways, above and below may refer to sides of a substrate or electronic device. Moreover, the scope of the present application is not intended to be limited to the particular embodiments of the process, machine, manufacture, composition of matter, means, methods and steps described in the specification. As one of ordinary skill in the art will readily appreciate from the disclosure, processes, machines, manufacture, compositions of matter, means, methods, or steps, presently existing or later to be developed that perform substantially the same function or achieve substantially the same result as the corresponding embodiments described herein may be utilized according to the present disclosure. Accordingly, the invention is defined by the appended claims.

## Claims

1. A package substrate, comprising:
a plurality of conductive layers (320); and
a dielectric interposed between the conductive layers (320), the dielectric including a stiffening material component (316) impregnated with a neat resin doped with a negative coefficient of thermal expansion, CTE, fiber (519).

2. The package substrate of claim 1, in which the negative CTE fiber comprises an aramid fiber.

3. The package substrate of claim 1, in which the stiffening material component comprises glass fibers.

4. The package substrate of claim 1, in which the package substrate is integrated into at least one of a mobile phone, a set top box, a music player, a video player, an entertainment unit, a navigation device, a computer, a hand-held personal communication system, PCS, unit, a portable data unit, and a fixed location data unit.

5. The package substrate of claim 1, wherein:
the dielectric interposed between the conductive layers has approximately 25% or less glass fibers,

6. The package substrate of claim 5, in which the package substrate is integrated into at least one of a mobile phone, a set top box, a music player, a video player, an entertainment unit, a navigation device, a computer, a hand-held personal communication system, PCS, unit, a portable data unit, and a fixed location data unit.

7. The package substrate of claim 1, wherein the dielectric has a thickness in the range of 35 to 45 microns.

8. A method, comprising:
forming a package substrate comprising a plurality of conductive layers (320) and a dielectric interposed between the conductive layers (320), the dielectric comprising a stiffening material component (316) impregnated with a neat resin; and
doping the neat resin of the dielectric with a negative coefficient of thermal expansion, CTE, fiber (519).

9. The method of claim 8, in which the negative CTE fiber comprises an aramid fiber.

10. The method of claim 8, in which the stiffening material component comprises glass fibers.

11. The method of claim 8, further comprising integrating the package substrate into at least one of a mobile phone, a set top box, a music player, a video player, an entertainment unit, a navigation device, a computer, a hand-held personal communication system, PCS, unit, a portable data unit, and a fixed location data unit.

12. The method of claim 8, wherein:
the dielectric between the conductive layers has approximately 25% or less glass fibers.

13. The method of claim 12, further comprising integrating the package substrate into at least one of a mobile phone, a set top box, a music player, a video player, an entertainment unit, a navigation device, a computer, a hand-held personal communication system, PCS, unit, a portable data unit, and a fixed location data unit.

14. The method of claim 8, wherein the dielectric has a thickness in the range of 35 to 45 microns.

## Patentansprüche

1. Ein Package- bzw. Gehäusesubstrat, das Folgendes aufweist:
eine Vielzahl von leitenden Schichten (320); und
ein Dielektrikum, das zwischen die leitenden Schichten (320) zwischengeordnet ist, wobei das Dielektrikum eine versteifende Materialkomponente (316) aufweist, die mit einem reinen Harz mit einem negativen thermischen Expansionskoeffizienten imprägniert ist, der mit einer Faser (519) mit negativem thermischem Expansionskoeffizient bzw. CTE (CTE = coefficient of thermal expansion) dotiert ist.

2. Gehäusesubstrat nach Anspruch 1, in dem die Faser mit negativem CTE eine Aramidfaser aufweist.

3. Gehäusesubstrat nach Anspruch 1, in dem die versteifende Materialkomponente Glasfasern aufweist.

4. Gehäusesubstrat nach Anspruch 1, in der das Gehäusesubstrat in wenigstens eines von einem Mobiltelefon, einer Set-Top-Box, einer Musikabspielvorrichtung, einer Videoabspielvorrichtung, einer Unterhaltungseinheit, einer Navigationseinrichtung, einem Computer, einer in der Hand gehaltenen Einheit eines persönlichen Kommunikationssystems bzw. PCS-Einheit (PCS = personal communication system), einer tragbaren Dateneinheit und einer Dateneinheit mit festem Standort integriert ist.

5. Gehäusesubstrat nach Anspruch 1, wobei
das Dielektrikum, das zwischen den leitenden Schichten zwischengelagert ist, ungefähr 25% oder weniger Glasfasern hat.

6. Gehäusesubstrat nach Anspruch 5, in dem das Gehäusesubstrat in wenigstens eines von einem Mobiltelefon, einer Set-Top-Box, einer Musikabspielvorrichtung, einer Videoabspielvorrichtung, einer Unterhaltungseinheit, einer Navigationseinrichtung, einem Computer, einer in der Hand gehaltenen Einheit eines persönlichen Kommunikationssystems bzw. PCS-Einheit, einer tragbaren Dateneinheit und einer Dateneinheit mit festem Standort integriert ist.

7. Gehäusesubstrat nach Anspruch 1, wobei das Dielektrikum eine Dicke in dem Bereich von 35 bis 45 Mikrometern hat.

8. Ein Verfahren, das Folgendes aufweist:
Bilden eines Gehäusesubstrats, das eine Vielzahl von leitenden Schichten (320) und ein Dielektrikum, das zwischen den leitenden Schichten (320) zwischengelagert ist, aufweist, wobei das Dielektrikum eine versteifende Materialkomponente (316) aufweist, die mit einem reinen Harz imprägniert ist; und
Dotieren des reinen Harzes des Dielektrikums mit einer Faser mit negativem thermischen Expansionskoeffizienten bzw. einer Faser mit negativem CTE (CTE = coefficient of thermal expansion) (519).

9. Verfahren nach Anspruch 8, in dem die Faser mit negativem CTE eine Aramidfaser aufweist.

10. Verfahren nach Anspruch 8, in dem die versteifende Materialkomponente Glasfasern aufweist.

11. Verfahren nach Anspruch 8, die weiter Integrieren des Gehäusesubstrats in wenigstens eines von einem Mobiltelefon, einer Set-Top-Box, einer Musikabspielvorrichtung, einer Videoabspielvorrichtung, einer Unterhaltungseinheit, einer Navigationseinrichtung, einem Computer, einer in der Hand gehaltenen Einheit eines persönlichen Kommunikationssystems bzw. PCS-Einheit, einer tragbaren Dateneinheit und einer Dateneinheit mit festem Standort aufweist.

12. Verfahren nach Anspruch 8, wobei
das Dielektrikum zwischen den leitenden Schichten ungefähr 25% oder weniger Glasfasern hat.

13. Verfahren nach Anspruch 12, das weiter Integrieren des Gehäusesubstrats in wenigstens eines von einem Mobiltelefon, einer Set-Top-Box, einer Musikabspielvorrichtung, einer Videoabspielvorrichtung, einer Unterhaltungseinheit, einer Navigationseinrichtung, einem Computer, einer in der Hand gehaltenen Einheit eines persönlichen Kommunikationssystems bzw. PCS-Einheit, einer tragbaren Dateneinheit und einer Dateneinheit mit festem Standort aufweist.

14. Verfahren nach Anspruch 8, wobei das Dielektrikum eine Dicke in dem Bereich von 35 bis 45 Mikrometern hat.

## Revendications

1. Substrat pour boîtier, comprenant :
une pluralité de couches conductrices (320) ; et
un diélectrique interposé entre les couches conductrices (320), le diélectrique comportant un composant en matériau raidisseur (316) imprégné d'une résine pure dopée avec une fibre à coefficient de dilatation thermique (CTE) négatif (519).

2. Substrat pour boîtier selon la revendication 1, dans lequel la fibre à CTE négatif comprend une fibre aramide.

3. Substrat pour boîtier selon la revendication 1, dans lequel le composant en matériau raidisseur comprend des fibres de verre.

4. Substrat pour boîtier selon la revendication 1, le substrat pour boîtier étant intégré dans au moins l'un d'un téléphone portable, d'un décodeur, d'un lecteur de musique, d'un lecteur vidéo, d'une unité de divertissement, d'un dispositif de navigation, d'un ordinateur, d'une unité de système de communication personnel (PCS) portable, d'une unité de données portable, et d'une unité de données de position fixe.

5. Substrat pour boîtier selon la revendication 1, dans lequel
le diélectrique interposé entre les couches conductrices comporte approximativement 25 % ou moins de fibres de verre.

6. Substrat pour boîtier selon la revendication 5, le substrat pour boîtier étant intégré dans au moins l'un d'un téléphone portable, d'un décodeur, d'un lecteur de musique, d'un lecteur vidéo, d'une unité de divertissement, d'un dispositif de navigation, d'un ordinateur, d'une unité de système de communication personnel (PCS) portable, d'une unité de données portable, et d'une unité de données de position fixe.

7. Substrat pour boîtier selon la revendication 1, dans lequel le diélectrique a une épaisseur dans la plage de 35 à 45 microns.

8. Procédé, comprenant :
la formation d'un substrat pour boîtier comprenant une pluralité de couches conductrices (320) et un diélectrique interposé entre les couches conductrices (320), le diélectrique comportant un composant en matériau raidisseur (316) imprégné d'une résine pure ; et
le dopage de la résine pure du diélectrique avec une fibre à coefficient de dilatation thermique (CTE) négatif (519).

9. Procédé selon la revendication 8, dans lequel la fibre à CTE négatif comprend une fibre aramide.

10. Procédé selon la revendication 8, dans lequel le composant en matériau raidisseur comprend des fibres de verre.

11. Procédé selon la revendication 8, comprenant en outre l'intégration du substrat pour boîtier dans au moins l'un d'un téléphone portable, d'un décodeur, d'un lecteur de musique, d'un lecteur vidéo, d'une unité de divertissement, d'un dispositif de navigation, d'un ordinateur, d'une unité de système de communication personnel (PCS) portable, d'une unité de données portable, et d'une unité de données de position fixe.

12. Procédé selon la revendication 8, dans lequel
le diélectrique interposé entre les couches conductrices comporte approximativement 25 % ou moins de fibres de verre.

13. Procédé selon la revendication 12, comprenant en outre l'intégration du substrat pour boîtier dans au moins l'un d'un téléphone portable, d'un décodeur, d'un lecteur de musique, d'un lecteur vidéo, d'une unité de divertissement, d'un dispositif de navigation, d'un ordinateur, d'une unité de système de communication personnel (PCS) portable, d'une unité de données portable, et d'une unité de données de position fixe.

14. Procédé selon la revendication 8, dans lequel le diélectrique a une épaisseur dans la plage de 35 à 45 microns.
